## Europäisches Patentamt

## European Patent Office

## Office européen des brevets

(19)

(11) **EP 1 204 185 A2**

(12) **EUROPÄISCHE PATENTANMELDUNG**

(43) Veröffentlichungstag:
**08.05.2002 Patentblatt 2002/19**

(51) Int Cl.[7]: **H02H 7/08**

(21) Anmeldenummer: **01123866.4**

(22) Anmeldetag: **05.10.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **02.11.2000 DE 10054176**

(71) Anmelder: **SIEMENS AKTIENGESELLSCHAFT**
**80333 München (DE)**

(72) Erfinder: **Eckardt, Dieter, Dr.**
**91074 Herzogenaurach (DE)**

(54) **Verfahren und Vorrichtung zur Ermittlung eines Betriebszustandes eines an einem starren Netz angeschlossenen Motors**

(57) Die Erfindung bezieht sich auf ein Verfahren und eine Vorrichtung (2) zur Ermittlung eines Betriebszustandes eines an einem starren Netz (6) angeschlossenen Motors (4), der einen Drehzahlsensor aufweist. Erfindungsgemäß werden aus an Anschlussklemmen (L1, L2, L3) des Motors (4) anstehenden Phasenspannungen ($u_1$, $u_2$, $u_3$) des starren Netzes (6) dessen Frequenz ($f_N$) und Amplitude ($U_1$) ermittelt, wird aus einer gemessenen Wellendrehzahl (n) und einer Polpaarzahl (p) des Motors (4) in Abhängigkeit der ermittelten Netzfrequenz ($f_N$) ein Schlupf (s) des Motors (4) berechnet, und wird in Abhängigkeit dieses Schlupfes (s), der ermittelten Amplitude ($U_1$), einer inneren Spannung ($U_{11}$) des Motors (4) und motorspezifischer Parameter ($X_1$, $X_2$, $X_h$, $R_2$, $R_1$, $R_{fe}$, σ) eine mechanische Wellenleistung ($P_{mech}$) berechnet. Somit erhält man ein leistungsunabhängiges Verfahren zur Ermittlung eines Betriebszustandes eines Motors (4), ohne dass eine Stromistwert-Erfassung vonnöten ist.

FIG 1

EP 1 204 185 A2

**Beschreibung**

Die Erfindung bezieht sich auf ein Verfahren und eine Vorrichtung zur Ermittlung eines Betriebszustandes eines an einem starren Netz angeschlossenen Motors, der einen Drehzahlsensor aufweist.

Der Betriebspunkt eines Motors an einem starren Netz ist beispielsweise die mechanische Wellenleistung, die der Motor an eine Arbeitsmaschine abgibt. Aus dem Vergleich dieser vom Motor abgegebenen mechanischen Wellenleistung und einer von der Arbeitsmaschine zulässigen mechanischen Wellenleistung kann man beispielsweise erkennen, ob die Arbeitsmaschinen in einem betriebsmäßigen Zustand ist. Der Betriebszustand kann sich auch beispielsweise aus der aktuellen Drehzahl, der mechanischen Wellenleistung und weiterer Information zusammensetzen.

Aus der europäischen Offenlegungsschrift 0 240 684 ist eine Einrichtung und ein Verfahren zum betriebsmäßigen elektronischen Verarbeiten von Betriebsdaten eines Elektromotors bekannt. Betriebsdaten des Motors sind beispielsweise Drehwinkel, Drehzahl, Drehbeschleunigung, Drehmoment, Leistung, thermische Belastung, Motorspannung und Motorstrom. In dieser Offenlegungsschrift wird für die Beanspruchung des Motors besonders der aussagekräftige Parameter Motorstrom beobachtet. Dieser wird mittels eines Stromsensors, z.B. ein Stromwandler, in der Zuleitung zum Motor erfasst, digitalisiert und einer zentralen Prozessoreinheit zugeführt. Diese Prozessoreinheit prüft nach einem im Programmspeicher abgelegten Programm fortlaufend die eingehenden Istwerte des Motorstromes auf Einhaltung vorgegebener Grenzwerte und registriert ferner Ein-, Um- und Ausschaltvorgänge. Die Prozessoreinheit ordnet solchen ausgewählten Betriebsdaten Daten über den absoluten Zeitpunkt ihres Auftretens zu und legt diese in einen Datenspeicher ab. Die Energieversorgung der Einrichtung ist so konzipiert, dass diese autark und betriebssicher arbeiten kann. Dieser Einrichtung wird zweckmäßig für längere Zeit, vorzugsweise für die gesamte Lebens- oder Einsatzzeit des Elektromotors, diesem eindeutig zugeordnet, d.h. die Einrichtung kann nicht für verschiedene Motoren gleichzeitig bzw. nacheinander verwendet werden, um klare Verhältnisse bei der Rekonstruktion der Motorbiographie zu haben. Da hier der Motorstrom verwendet wird, ist diese Einrichtung leistungsabhängig. Das heißt, dass mit Anstieg des Motorstromes der Stromwandler gewechselt werden muss.

Aus dem Fachbericht "Intelligenter Motorschutz", von Dietrich Amft und Peter Waber, abgedruckt in 10. Internationale Fachtagung, "Industrielle Automatisierung - automatisierte Antriebe", der Technischen Universität Karl-Marx-Stadt, vom 14. bis 16. Februar 1989, ist ein universelles Schaltungskonzept bekannt, das aus Funktionsmodulen besteht, die auch einzeln verschaltet werden können. Als Funktionsmodul sind Wandlerbaugruppen zur Erfassung der Motorzuleitungsströme, Analog/Digital-Wandler, eine Baugruppe zur Ermittlung der Motortemperatur über Wicklungsfühler, eine Rechnerbaugruppe zur Temperaturberechnung, Schnittstelle für die Kommunikation, eine Filterbaugruppe zur Bewertung von Stromoberwellen, eine Summenstromwandler-Baugruppe, eine Funktionseingabe, ein Display und eine Stromversorgungs-Baugruppe, vorgesehen. Die Rechnerbaugruppe weist einen Ein-Chip-Mikroprozessor auf. Über das Display können Einstellstrom, Iststrom und Temperatur sowie codierte Fehler angezeigt werden. Ab einem Stromistwert von 80 % bis 100 % des Nennwertes erfolgt eine Warnung, wogegen bei Überschreitung des Nennwertes eine verzögerte Auslösung stattfindet.

Aus der EP 0 675 369 B1 ist ein Online-Diagnosesystem für rotierende umlaufende elektrische Maschinen bekannt, mit dem der Zustand und der Wartungsbedarf einer Arbeitsmaschine diagnostiziert wird. Dieses System weist mehrere Motorsensoren auf, welche verschiedene physikalische Parameter überwachen und entsprechende elektrische Signale erzeugen. Signalwandler setzen die elektrischen Signale in entsprechende Digitalwerte um. Diese Werte werden von einem Prozessor gesammelt, der diese Werte oder einen Trend der Werte mit vorgegebenen Basiswerten oder Trends vergleicht. Der Prozessor macht dann Empfehlungen für ein Motorwartungsintervall, um eine optimale Leistungsfähigkeit und Verfügbarkeit bei minimalen Kosten und minimaler Stillstandszeit zu erhalten.

Der Erfindung liegt nun die Aufgabe zugrunde, ein Verfahren und eine Vorrichtung zur Ermittlung eines Betriebszustandes eines an einem starren Netz angeschlossenen Motors anzugeben, das leistungsunabhängig ist.

Diese Aufgabe wird erfindungsgemäß mit den Merkmalen des Anspruchs 1 bzw. des Anspruchs 12 gelöst.

Dadurch, dass zur Ermittlung eines Betriebszustandes eines an einem starren Netz angeschlossenen Motors, der einen Drehzahlsensor aufweist, die an den Anschlussklemmen des Motors anstehenden Phasenspannungen und nicht der in den Motor fließende Strom ausgewertet werden, kann das Verfahren und die Vorrichtung unabhängig von der Leistung der Motoren bei jedem Motor angewendet werden. Aus diesen Netzspannungen werden deren Frequenz und Amplitude ermittelt, aus denen in Zusammenhang mit einer ermittelten Wellendrehzahl, einer Polpaarzahl des Motors und motorspezifischer Parameter eine mechanische Wellenleistung als Betriebszustand berechnet wird. Die Phasenspannungen des starren Netzes werden für dieses Verfahren nicht direkt gemessen, sondern es werden diese an den Anschlussklemmen des Motors anstehenden Phasenspannungen hinsichtlich der Frequenz und der Amplitude ausgewertet.

Da diese an den Anschlussklemmen anstehenden Phasenspannungen des starren Netzes für die Vorrichtung zur Ermittlung eines Betriebszustandes nur ausgewertet werden, benötigt die Vorrichtung keine Spannungswandler. Da weder Strom noch Spannungswandler für die Vorrichtung benötigt werden, ist der Aufbau dieser Vorrichtung von der Leistung eines zugehörigen Motors unabhängig. Somit ist diese Vorrichtung nahezu leistungsunabhängig zu verwenden.

Die Vorrichtung ist in eine analoge Auswerteschaltung und einer digitalen Recheneinheit unterteilt. Mittels der analogen Auswerteschaltung werden die an den Anschlussklemmen des Motors anstehenden Phasenspannungen eines starren Netzes hinsichtlich der Frequenz und der Amplitude ausgewertet. Die digitale Recheneinheit bestimmt aus den ermittelten Frequenz- und Amplitudenwert, einer gemessenen Wellendrehzahl, einer Polpaarzahl des zugehörigen Motors und motorspezifischer Parameter einen Betriebszustand, beispielsweise die mechanische Wellenleistung. Da die analoge Auswerteschaltung wenige Bauelemente aufweist und die digitale Recheneinheit vorzugsweise ein Bauelement sein kann, ist der Verdrahtungsaufwand minimal. Außerdem ist das beanspruchte Bauvolumen minimal.

Der erfinderische Schritt ist darin zu sehen, dass die an den Anschlussklemmen des Motors anstehenden Phasenspannungen eines starren Netzes für die Ermittlung eines Betriebzustandes eines an diesen Netz angeschlossenen Motors verwendet werden. Das heißt, man hat sich von der Verwendung von Stromwandler abgewendet, da diese leistungsbezogen ausgeführt sind, wodurch unterschiedliche Vorrichtungen, die in Leistungsklassen unterteilt sind, für Motoren unterschiedlicher Leistungen vorhanden sein müssen.

Der Betriebszustand eines Motors ist nicht nur durch einen einzigen Wert, beispielsweise der mechanischen Wellenleistung, festgelegt, sondern kann sich aus mehreren Werten zusammensetzen.

Bei einem vorteilhaften Verfahren wird mittels einer Auswertung einer zeitlichen Abfolge ermittelter Spannungsabschnitte der an den Anschlussklemmen anstehenden Phasenspannungen des starren Netzes die Drehrichtung des Netzes an den Anschlussklemmen des Motors ermittelt. Die Drehrichtung des Netzes an den Anschlussklemmen des Motors gibt die Drehrichtung des Motors vor. Da die Drehrichtung aus den anstehenden Phasenspannungen ermittelt werden können, genügt als Drehzahlsensor ein einfacher Strichgeber oder Zahnradgeber, die keine Drehrichtung erkennen können.

Es kann vorkommen, dass eine Phase des starren Netzes am Motor aus irgendwelchen Gründen ausfällt, ohne eine Phasenausfallerkennung muss zum sicheren Schutz der Wicklung des Motors vor Übertemperatur an jeder Wicklung ein Temperaturfühler angebracht bzw. in diese eingelegt werden. Mit einer Phasenausfallerkennung kann eine Verminderung der Temperaturfühler auf einen erreicht werden, der in irgendeiner Wicklung des Motors eingelegt ist.

Bei einem weiteren vorteilhaften Verfahren wird mittels einer Auswertung einer zeitlichen Abfolge ermittelter Spannungsabschnitte der an den Anschlussklemmen des Motors anstehenden Phasenspannungen und einer Amplitudenauswertung dieser Spannungsabschnitte ein Phasenausfall des Netzes ermittelt.

Bei einem weiteren vorteilhaften Verfahren wird mittels einer gemessenen Temperatur des Ständers und eines thermischen Modells des Motors die Temperatur des Läufers ermittelt. Durch die Berechnung der Temperatur des Läufers besteht nun die Möglichkeit, an temperaturabhängigen Parameter Läuferwiderstand zu korrigieren. In gleicher Weise kann mit dem Parameter Ständerwiderstand verfahren werden, indem die gemessene Ständertemperatur direkt bei der Korrekturrechnung verwendet wird.

Bei einer vorteilhaften Vorrichtung zur Ermittlung eines Betriebszustandes eines Motors weist die analoge Auswerteschaltung eine mehrphasige Diodenbrücke auf, die ausgangsseitig mit einem RC-Glied und einer Einrichtung zur Unterdrückung eines Gleichanteils versehen ist. Außerdem ist elektrisch parallel zum RC-Glied ein hochohmiger Widerstand geschaltet, damit am Ausgang der Einrichtung zur Unterdrückung eines Gleichanteils ein Rippelsignal der gleichgerichteten Netzspannung ansteht. Die digitale Recheneinheit ermittelt aus diesen Rippelsignal die Netzfrequenz.

Bei einer weiteren vorteilhaften Ausführungsform der Vorrichtung zur Ermittlung eines Betriebszustandes eines Motors werden anstelle der Einrichtung zur Unterdrückung eines Gleichanteils mehrere Triggerschaltungen verwendet, die eingangsseitig jeweils mit einem Eingang der mehrphasigen Diodenschaltung und ausgangsseitig mit einem Eingang der digitalen Recheneinheit verbunden sind. Durch die Verwendung der Triggerschaltung wird die Frequenzbestimmung deutlich verbessert. Außerdem vereinfacht sich die Ermittlung eines Phasenausfalls, da nun die zeitliche Abfolge der ermittelten Spannungsabfälle an den Dioden der unteren Brückenseite der mehrphasigen Diodenbrücke und die Amplitude dieser ermittelten Spannungsabfälle ausgewertet werden.

Bei einer weiteren vorteilhaften Ausführungsform der Vorrichtung zur Ermittlung eines Betriebszustandes eines Motors wird anstelle einer jeder Triggerschaltung ein Optokoppler verwendet, die jeweils elektrisch in Reihe zu den Dioden der unteren Diodenseite der Diodenbrücke geschaltet sind. Auf diese Weise werden die Stromführungszeiten der Dioden der unteren Diodenseite der Diodenbrücke potentialfrei ermittelt.

Bei einer besonders vorteilhaften Ausführungsform ist zum hochohmigen Widerstand, der elektrisch parallel zum RC-Glied der analogen Auswerteschaltung geschaltet ist, elektrisch in Reihe ein elektrischer Schalter geschaltet, der steuerungsseitig mit der digitalen Recheneinheit verbunden ist, wobei diese Verbindung einen Optokoppler zur Potentialtrennung aufweist. Mit diesem Schalter wird der hochohmige Widerstand nur zu bestimmten Zeitpunkten eingeschaltet. In Abhängigkeit des Tastverhältnisses wird die Verlustleistung dieses hochohmigen Widerstandes reduziert. Wird der Schalter auf die natürlichen Kommutierungszeitpunkte der mehrphasigen Diodenbrücke synchronisiert, kann neben der Ermittlung eines Phasenausfalls auch noch die Netzfrequenz ermittelt werden. Außerdem wird dann die durch den hochohmigen Widerstand verursachte Verlustleistung minimal. Dieser getaktete hochohmige Widerstand kann auch bei den anderen Ausführungsformen verwendet werden, wenn man die Vorrichtung zur Ermittlung eines Betriebszustandes eines Motors verlustarm ausgestalten möchte.

Vorteilhafte Ausgestaltungen der erfindungsgemäßen Vorrichtung zur Ermittlung eines Betriebszustandes eines an einem starren Netz angeschlossenen Motors sind den Unteransprüchen 12 bis 30 zu entnehmen.

Zur weiteren Erläuterung der Erfindung wird auf die Zeichnung Bezug genommen, in der mehrere Ausführungsformen der erfindungsgemäßen Vorrichtung zur Ermittlung eines Betriebszustandes eines an einem starren Netz angeschlossenen Motors schematisch veranschaulicht sind.

FIG 1     zeigt eine erste Ausführungsform der Vorrichtung zur Ermittlung eines Betriebszustandes eines Motors, in der

FIG 2     sind die Phasenspannungen des starren Netzes in einem Diagramm über die Zeit t aufgetragen, die

FIG 3     zeigt in einem Diagramm über die Zeit t ein Rippelsignal der gleichgerichteten Netzspannung, in der

FIG 4     ist das einphasige Ersatzschaltbild eines Motors dargestellt, die

FIG 5     zeigt eine weitere Ausführungsform der Vorrichtung nach FIG 1, in der

FIG 6     sind die Blockströme der dreiphasigen Diodenbrücke der Vorrichtung nach FIG 1 dargestellt, die

FIG 7     zeigt ein Zustandsdiagramm für die Ermittlung Rechts-/Linkslauf des Motors, die

FIG 8     zeigt eine weitere Ausführungsform der Vorrichtung nach FIG 1, die

FIG 9     zeigt einen Motor kleiner Achshöhe mit der einer erfindungsgemäßen Vorrichtung und die

FIG 10     zeigt einen Motor größerer Achshöhe mit einer erfindungsgemäßen Vorrichtung.

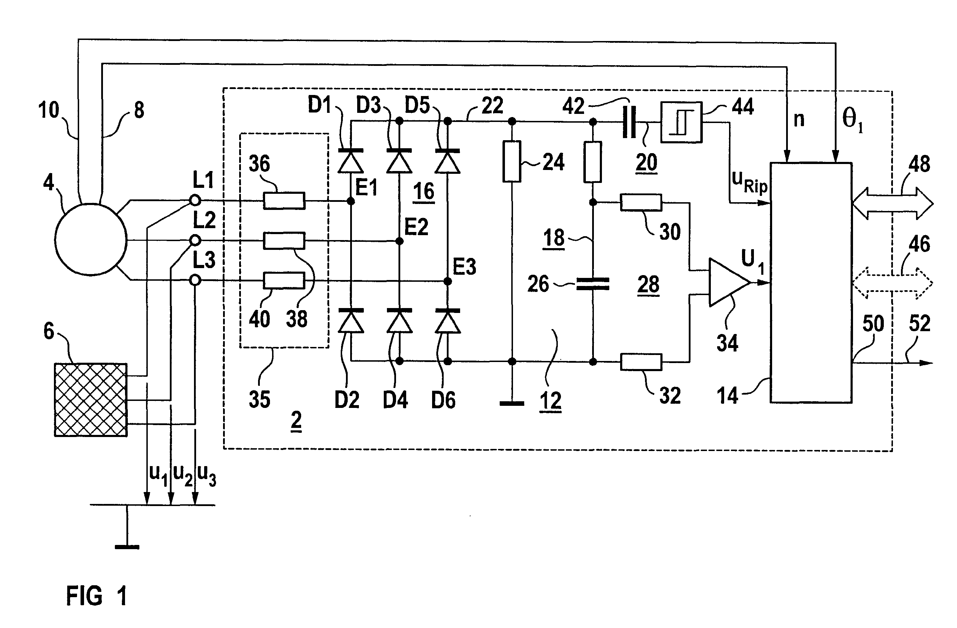

FIG 1 zeigt eine erste Ausführungsform einer Vorrichtung 2 zur Ermittlung eines Betriebszustandes eines Motors 4 an einem starren Netz 6 nach der Erfindung. Der Motor 4 weist einen Drehzahlsensor auf, der beispielsweise im Motor 4 angeordnet ist. Vom Motor 4 sind zwei Signalleitungen 8 und 10 für eine gemessene Wellendrehzahl n und einer gemessenen Temperatur $\theta_1$, die mittels eines in der Wicklung des Ständers des Motors 4 angebrachten Temperatursensors ermittelt wird. Der Motor 4 ist mittels seiner Anschlussklemmen L1, L2 und L3 mit den Phasenleitungen des starren Netzes 6 verknüpft. An diesen Anschlussklemmen L1, L2 und L3 ist ebenfalls die Vorrichtung 2 eingangsseitig angeschlossen. Die Vorrichtung 2 weist eine analoge Auswerteschaltung 12 und eine digitale Recheneinheit 14 auf. Die analoge Auswerteschaltung 12 bildet den Eingang der Vorrichtung 2, deren Eingänge E1, E2 und E3 mit den Anschlussklemmen L1, L2 und L3 des Motors 4 verbunden sind. Die Signalleitungen 8 und 10 des Motors 4 sind jeweils mit einem Signaleingang der digitalen Recheneinheit 14 verknüpft. Ausgangsseitig ist die analoge Auswerteschaltung 12 ebenfalls mit Signaleingängen der digitalen Recheneinheit 14 verbunden.

Die analoge Auswerteschaltung 12 weist eingangsseitig eine mehrphasige Diodenbrücke 16 auf, die hier dreiphasig ausgebildet ist. Ausgangsseitig weist diese analoge Auswerteschaltung 12 ein RC-Glied 18 und eine Einrichtung 20 zur Unterdrückung eines Gleichanteils auf. Das RC-Glied 18 ist elektrisch parallel zum gleichspannungsseitigen Ausgang der mehrphasigen Diodenbrücke 16 geschaltet, wobei die Einrichtung 20 zur Unterdrückung eines Gleichanteils eingangsseitig mit einem positiven Anschluss 22 des gleichspannungsseitigen Ausgangs der mehrphasigen Diodenbrücke 16 verbunden ist. Elektrisch parallel zum gleichspannungsseitigen Ausgang der mehrphasigen Diodenbrücke 16 und damit auch elektrisch parallel zum RC-Glied 18 ist ein hochohmiger Widerstand 24 geschaltet. Ohne diesen hochohmigen Widerstand 24 würde sich am positiven Anschluss 22 des gleichspannungsseitigen Ausgangs der mehrphasigen Diodenbrücke 16 kein Rippelsignal $u_{Rip}$ einstellen, da durch das RC-Glied 18 die gleichgerichtete Spannung geglättet ist. Der Nachteil dieses hochohmigen Widerstandes 24 ist, dass die analoge Auswerteschaltung 12 dadurch verlustbehaftet ist.

Dem Kondensator 26 des RC-Gliedes 18 ist parallel ein Pegelumsetzer 28 geschaltet, dessen Ausgang mit einem Signaleingang der digitalen Recheneinheit 14 verknüpft ist. Dieser Pegelumsetzer 28 weist zwei hochohmige Widerstände 30 und 32 und einen Ausgangsverstärker 34 auf. Die beiden Eingänge dieses Ausgangsverstärker 34 sind jeweils über diesen hochohmigen Widerstand 30 bzw. 32 mit einem Anschluss des Kondensators 26 des RC-Gliedes 18 verbunden. Am Ausgang dieses Pegelumsetzers 28 steht ein Signal an, das direkt proportional zur Amplitude $U_1$ der Netzspannung u ist.

Zur sicheren elektrischen Trennung der analogen Auswerteschaltung 12 mit nachgeschalteter digitaler Recheneinheit 14 vom starren Netz 6 ist eine Einrichtung 35 vorgesehen. Diese Einrichtung 35 zur sicheren Trennung weist in der Ausführungsform nach FIG 1 hochohmige Vorwiderstände 36, 38 und 40 auf, die zwischen den Anschlussklemmen L1, L2 und L3 des Motors 4 und den Eingängen E1, E2 und E3 der analogen Auswerteschaltung 12 geschaltet sind. Die Einrichtung 35 zur sicheren elektrischen Trennung kann anstelle der drei hochohmigen Vorwiderstände 36, 38 und 40 einen Mehrphasentransormator oder auch drei Einphasentransformatoren aufweisen. Außerdem kann die Einrichtung 35 auch einen Pegelumsetzer aufweisen. Welche Ausführungsform für die Einrichtung 35 verwendet wird, bleibt den Anwender überlassen der entscheiden muss, ob er beispielsweise aus Platzgründen die Vorwiderstände 36, 38 und 40 verwendet und dafür die entstehende Verlustleistung akzeptieren muss. In der jeweiligen Ausführungsform der erfindungsgemäßen Vorrichtung 2 zur Ermittlung eines Betriebszustandes eines an einem starren Netz 6 angeschlossenen Motors 4 nach den FIG 1, 5 und 8 ist jeweils die Einrichtung 35 in der Ausführungsform Vorwiderstände 36, 38 und 40 veranschaulicht.

Der Einrichtung 20 zur Unterdrückung eines Gleichanteils weist eingangsseitig einen Kondensator 42 zum Abblocken eines Gleichanteils und ausgangsseitig eine Triggerschaltung 44 auf, die eingangsseitig mit einem Anschluss des Kondensators 42 verschaltet ist. Am Ausgang der Triggerschaltung 44 steht ein Rippelsignal $u_{Rip}$, das der digitale Recheneinheit 14 zugeführt wird.

Die digitale Recheneinheit kann über eine Schnittstelle 46 (seriell oder parallel) verfügen, über die motorspezifische Parameter - Hauptinduktivität $X_h$, Ständerinduktivität $X_1$, Läuferinduktivität $X_2$, Läuferwiderstand $R_2$, Ständerwiderstand $R_1$, Steuerung $\sigma$, Polpaarzahl p, Temperaturbeiwerte $\kappa_1$, $\kappa_2$ - in die digitale Recheneinheit 14 eingelesen werden. Außerdem hat diese digitale Recheneinheit 14 eine weitere Schnittstelle 48 (seriell oder parallel), an der ein Standardbus-System, wie z.B. Profibus, Ethernet und ASI angeschlossen werden kann. Die digitale Recheneinheit 14 kann ein Mikrocomputer bzw. ein Mikroprozessor bzw. ein Kleinst-PC, beispielsweise ein Single-Chip-PC, sein. Außerdem kann die digitale Recheneinheit 14 ein **P**rogrammable **L**ogic **D**evice (PLD) sein. Unabhängig von der Ausführungsform der digitalen Recheneinheit 14 verfügt diese zumindest über einen nicht flüchtigen Speicher zum Abspeichern von motorspezifischen Parametern $X_1$, $X_2$, $X_h$, $R_1$, $R_2$, $\sigma$, p, $\kappa_1$, $\kappa_2$ einen Festwertspeicher, in dem das Programm der digitalen Recheneinheit 14 abgelegt ist, und einen Schreib-Lese-Speicher, der als Arbeitsspeicher der digitalen Recheneinheit 14 dient. Ferner verfügt die digitale Recheneinheit 14 über einen Meldeausgang 50, an dem eine Meldeleitung 52 angeschlossen werden kann. Diese Meldeleitung 52 verbindet beispielsweise diese Vorrichtung mit einem Schaltgerät am Motor 14 oder mit einer übergeordneten Steuerung.

Im folgenden soll nun die Funktionsweise dieser Vorrichtung 2 zur Ermittlung eines Betriebszustandes eines an einem starren Netz 6 angeschlossenen Motors 4 beschrieben werden:

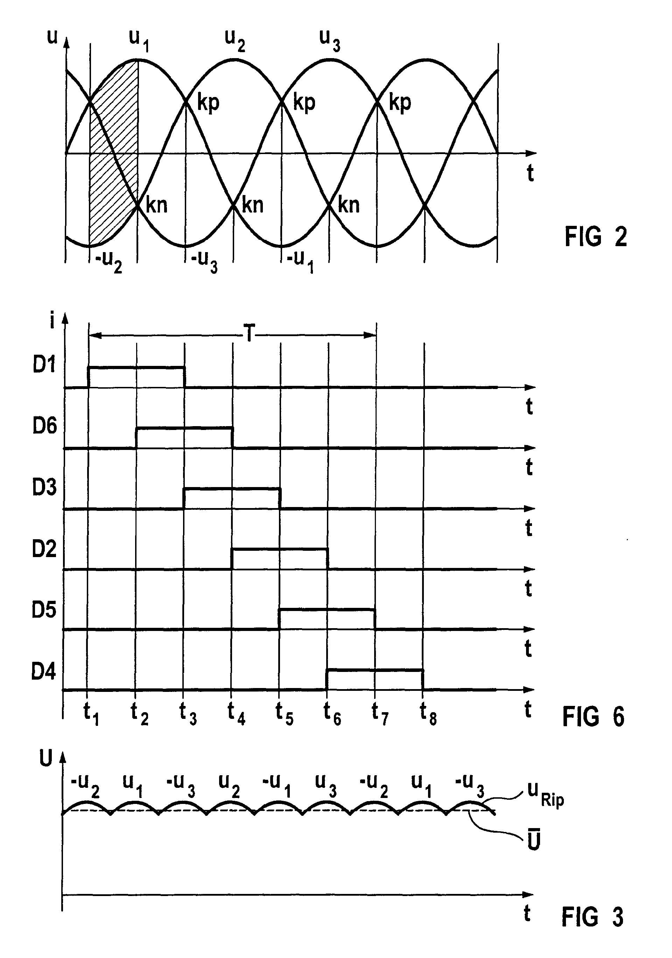

Die an den Anschlussklemmen L1, L2 und L3 des Motors 4 anstehenden Phasenspannungen $u_1$, $u_2$ und $u_3$ des starren Netzes 6 stehen auch potentialgetrennt an den Eingängen E1, E2 und E3 der analogen Auswerteschaltung 12 an. Die eingangsseitige mehrphasige Diodenschaltung 16 der analogen Auswerteschaltung 12 richtet diese Phasenspannungen $u_1$, $u_2$ und $u_3$, die in dem Diagramm der FIG 2 über die Zeit t dargestellt sind, gleich. Am positiven Anschluss des gleichspannungsseitigen Ausgangs der mehrphasigen Diodenbrücke 16 erhält man diese gleichgerichtete Spannung U, die gemäß der Darstellung der FIG 3 einen Gleichanteil $\bar{U}$ und einen Rippel $u_{Rip}$ aufweist. Mittels der Einrichtung 20 wird der Gleichanteil $\bar{U}$ unterdrückt und der verbleibende Rippel $u_{Rip}$ getriggert an die digitale Recheneinheit 14 weitergeleitet. Die gleichgerichtete Netzspannung steht auch am RC-Glied 18 an, das diese gleichgerichtete Netzspannung glättet. Dieses geglättete Signal wird mittels des Pegelumsetzers 28 an die digitale Recheneinheit 14 weitergeleitet. Dieses geglättete Signal ist direkt proportional zur Amplitude der Netzspannung u und bei vorausgesetzten sinusförmigen Phasenspannungen $u_1$, $u_2$ und $u_3$ auch direkt proportional zu dessen Effektivwert.

In der digitalen Recheneinheit 14 sind nun die motorspezifischen Parametern $X_1$, $X_2$, $X_h$, $R_1$, $R_2$, $\sigma$, p, die Messwerte Wellendrehzahl n und Temperatur $\theta_1$ des Ständers, Temperaturbeiwert $\kappa_1$ für den Ständer, Temperaturbeiwert $\kappa_2$ für den Läufer, der Effektivwert U1 der Netzspannung u und das Rippelsignal $u_{Rip}$ eingelesen. Zunächst wird in Abhängigkeit des Rippelsignals $u_{Rip}$ durch Zählen der Rippel die Netzfrequenz $f_N$ ermittelt. Die Anzahl der Rippel pro Zählperiode geteilt durch die feste Zahl sechs ergibt die Netzfrequenz $f_N$. In Abhängigkeit dieser Netzfrequenz $f_N$ und der Polpaarzahl p des Motors 4 wird die synchrone Drehzahl $n_s$ des Motors 4 gemäß folgender Gleichung:

$$n_s = \frac{f_N \cdot 60}{p} \qquad (1)$$

berechnet. Mit dieser synchronen Drehzahl $n_s$ und der gemessenen Wellendrehzahl n wird der Schlupf s des Motors 4 gemäß folgender Gleichung:

$$s = \frac{n_s - n}{n_s} \qquad (2)$$

berechnet.

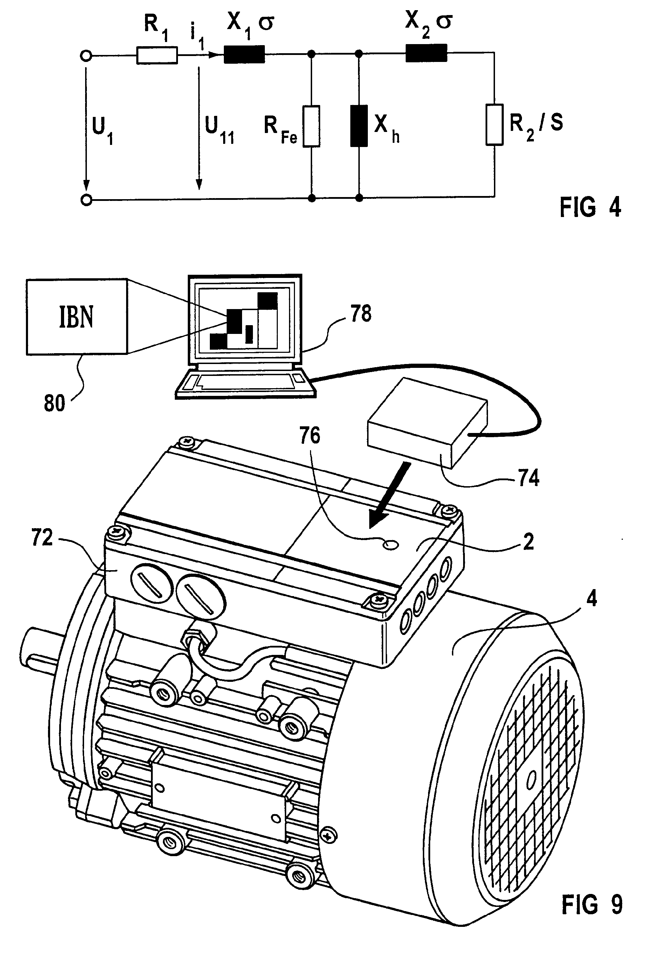

Mit Hilfe des einphasigen Ersatzschaltbildes des Motors 4 gemäß FIG 4 und den bekannten motorspezifischen Parametern $X_1$, $X_2$, $X_h$, $R_1$, $R_2$ und $\sigma$ sowie des berechneten Schlupfes s und des ermittelten Effektivwertes $U_1$ der Netzspannung u kann der Ständerstrom $I_1$ des Motors 4 berechnet werden. In Abhängigkeit dieses berechneten Ständerstromes $I_1$ der ermittelten Netzspannung $U_1$ und des eingelesenen Parameters Ständewiderstand $R_1$ wird eine Spannung $U_{11}$ berechnet, die gegenüber der Netzspannung $U_1$ und dem Spannungsabfall am Ständewiderstand $R_1$

vermindert ist. Aus diesem Grund wird diese Spannung $U_{11}$ auch als innere Spannung des Motors 4 bezeichnet. Mit den ermittelten Werten $U_{11}$, $n_s$ und s und den bereits eingelesenen motorspezifischen Parametern $X_1$, $X_2$, $X_h$, $R_2$, $\sigma$ wird die mechanische Wellenleistung $P_{mech}$ beispielsweise gemäß folgender Gleichung:

$$P_{mech} = 3 \cdot X_h^2 / X_1^2 \cdot U_{11}^2 \cdot R_2 \cdot s / \left( R_2^2 + (\sigma \cdot X_2 \cdot s)^2 \right) \cdot (1 - s) \qquad (3)$$

berechnet. Durch den Wert dieser mechanischen Wellenleistung $P_{mech}$ ist der Betriebszustand des Motors 4 ermittelt.

Mit Hilfe des berechneten Ständerstromes $I_1$ kann nun die Verlustleistung $P_{V1}$ des Ständers des Motors 4 berechnet werden, die sich zusammensetzen aus den ohmschen Verlusten und den Eisenverlusten.

Die ohmschen Verluste $P_{1V1}$ werden gemäß folgender Gleichung:

$$P_{1V1} = 3 \cdot R_1 \cdot (|I_1|)^2 \qquad (4)$$

berechnet. In Abhängigkeit der mechanischen Wellenleistung $P_{mech}$ und des Schlupfes s wird gemäß folgender Gleichung:

$$P_{LS} = P_{mech}/(1 - s) \qquad (5)$$

die Luftspaltleistung $P_{LS}$ des Motors 4 und damit in Verbindung mit dem Schlupf s gemäß folgender Gleichung:

$$P_{V2} = P_{LS} \cdot s \qquad (6)$$

die Verlustleistung $P_{V2}$ des Läufers berechnet.

Die Eisenverluste werden gemäß folgender Gleichung:

$$P_{Fe} = 3 \cdot |U_1| \cdot |I_1| \cdot \cos \varphi(s) - P_{1V1} - P_{V2} - P_{mech} \qquad (7)$$

berechnet, wobei der Leistungsfaktor $\cos\varphi$ gemäß folgender Gleichung:

$$\cos \varphi = \cos(\varphi_u - \varphi_i) \qquad (8)$$

berechnet wird, mit

$\varphi_u$ = Phasenlage der Netzspannung $U_1$
$\varphi_i$ = Phasenlage des Motorstromes $I_1$

Mit diesen zuvor berechneten Leistungen $P_{V1}$, $P_{V2}$ und $P_{mech}$ kann man den Wirkungsgrad $\eta$ des Motors 4 in Abhängigkeit des Schlupfes s berechnen. Auch dieser berechnete Wirkungsgrad $\eta$ ist ein Element des Betriebszustandes des Motors 4.

Da die Parameter Ständerwiderstand $R_1$ und Läuferwiderstand $R_2$ temperaturabhängig sind, ist es ratsam, diese Parameter betriebspunktabhängig nachzuführen. Dazu wird die gemessene Temperatur $\theta_1$ des Ständers des Motors 4 verwendet. Mit Hilfe dieser gemessenen Temperatur $\theta_1$ und einem thermischen Modell des Motors 4 kann man die Temperatur $\theta_2$ des Läufers des Motors 4 berechnen. Gemäß folgender Gleichung:

$$R(T) = R_{20} \cdot (1 + \kappa \cdot (T - T_{20})) \qquad (9)$$

können nun die temperaturabhängigen Parameter Ständer- und Läuferwiderstand $R_1$ und $R_2$ betriebspunktabhängig korrigiert werden. Der Temperaturbeiwert $\kappa_1$ und $\kappa_2$ für den Ständer und den Läufer des Motors 4 sind zusammen mit den motorspezifischen Parametern in der digitalen Recheneinheit 14 eingelesen worden. Da nun die temperaturabhängigen Parameter Ständer- und Läuferwiderstand $R_1$ und $R_2$ betriebspunktabhängig korrigiert sind, wird die mechanische Wellenleistung $P_{mech}$ immer exakt berechnet.

In Abhängigkeit des Rippelsignals $u_{Rip}$ kann mit der Vorrichtung 2 zur Ermittlung eines Betriebszustandes eines Motors 4 auch noch einen Phasenausfall des Netzes 6 ermittelt werden. Wenn eine Phase des Netzes 6 aus irgendeinem Grund ausfällt, so fehlt an den Anschlussklemmen L1, L2 und L3 des Motors 4 eine der drei Phasenspannungen $u_1$, $u_2$ und $u_3$. Dadurch weist das Rippelsignal $u_{Rip}$ Lücken auf, die von der digitalen Recheneinheit 14 erkannt werden. Damit ist die Bestimmung der schadhaften Phase möglich.

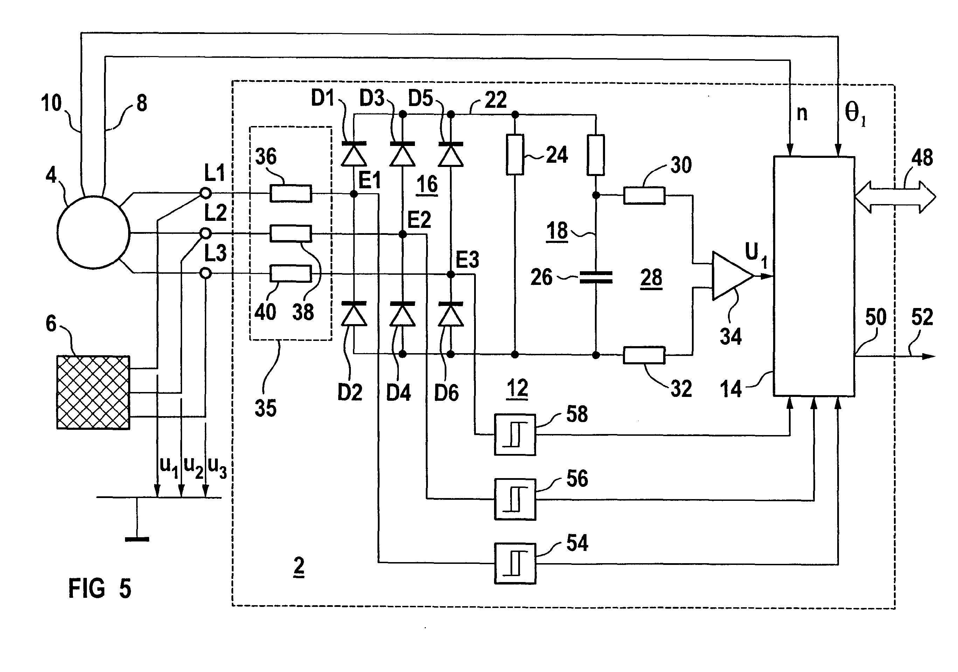

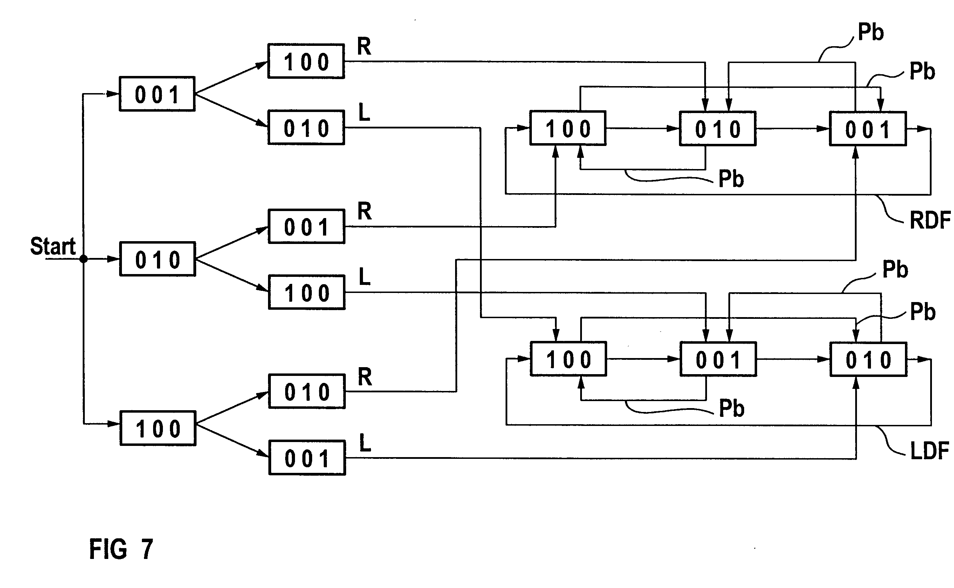

In der FIG 5 ist eine vorteilhafte Ausführungsform der Vorrichtung 2 nach FIG 1 näher dargestellt. Diese vorteilhafte Ausführungsform unterscheidet sich von der Ausführungsform gemäß FIG 1 dadurch, dass anstelle der Einrichtung 20 zur Unterdrückung eines Gleichanteils entsprechend der Phasenzahl der mehrphasigen Diodenbrücke 16 Triggerschaltungen 54, 56 und 58 vorgesehen sind. Diese Triggerschaltungen 54, 56 und 58 sind eingangsseitig jeweils mit einem Eingang E1, E2 und E3 der analogen Auswerteschaltung 12 verbunden, die gleichseitig wechselspannungsseitige Eingänge der mehrphasigen Diodenbrücke 16 sind. Ausgangsseitig sind diese Triggerschaltungen 54, 56 und 58 jeweils mit einem Signaleingang der digitalen Recheneinheit 14 verbunden. Das Diagramm gemäß FIG 6 zeigt die Ströme durch die einzelnen Dioden D1,...,D6 der mehrphasigen Diodenbrücke 16 über der Zeit t. Die inversen Signale dazu sind proportional der Spannungsabfälle an den Dioden D1,...,D6 dieser mehrphasigen Diodenbrücke 16. Mit den Triggerschaltungen 54, 56 und 58 werden diese Spannungsabfälle an den Dioden D2, D4 und D6 der unteren Brückenseite der mehrphasigen Diodenbrücke 16 ermittelt. Die digitale Recheneinheit 14 beurteilt nicht nur diese Spannungsabfälle, sondern auch deren zeitliche Abfolge. Die Triggerschaltungen 54, 56 und 58 sind derart ausgeführt, dass bei einem Phasenbruch das Potential zwischen der zugehörigen oberen und unteren Diode D1, D2 bzw. D3, D4 bzw. D5, D6 stets ein vorbestimmtes Potential annimmt. Somit kann die digitale Recheneinheit 14 in Abhängigkeit der Beurteilung der ermittelten Spannungsabfälle erkennen, ob ein Phasenbruch vorliegt und in welcher Phase des Netzes 6 dieser Phasenbruch auftritt. Trotz eines auftretenden Phasenbruches dreht sich der Motor 4 weiter; er kann nur nicht mehr anlaufen. Die Folge ist jedoch, eine Erhöhung der Temperatur in der Wicklung des Ständers.

Durch die zeitliche Abfolge der Spannungsabfälle an den Dioden D2, D4 und D6 der Diodenbrücke 16 der analogen Auswerteschaltung 12 der Vorrichtung 2 zur Ermittlung eines Betriebszustandes eines Motors 4 kann die Drehrichtung des Motors 4 erkannt werden. Anhand des Zustandsdiagramms gemäß FIG 7 wird die Ermittlung der Drehrichtung des Motors 4 näher erläutert:

In diesem Zustandsdiagramm sind die stromführenden Dioden jeweils mit Eins und die sperrenden Dioden jeweils mit einer Null gekennzeichnet. Wegen der Übersichtlichkeit sind nur zwei Taktperioden und die von der zweiten Taktperiode ausgehenden Übergänge gezeigt, die zu einem regulären, d.h. phasenbruchfreien Verhalten, führen. Grundsätzlich gilt, dass jeder Übergang von einem Zustand der zweiten Taktperiode zu einem anderen als den gezeigten Zustand, einen Phasenbruch Pb kennzeichnet. Um Fehlinterpretationen auszuschließen, müssen die kurzzeitig während der Kommutierung des Stromes von einer Diode auf die andere auftretenden Zustände, in denen zwei Dioden gleichzeitig leiten, ausgeblendet werden. Durch Messung der Dauer für die die jeweilige Diode leitet, kann, zumindest im stationären Betriebszustand, auch bis zu einem Grad auf die Symmetrie des Netzes geschlossen werden.

In der ersten Taktperiode dieses Zustandsdiagramms ist nach dem Start entweder die Diode D2 oder D4 oder D6 leitend. Nimmt man an, dass die Diode D2 der mehrphasigen Diodenbrücke 16 leitend ist, so ist in der ersten Taktperiode der Zustand 100. Nach einer Kommutierung können nur die Zustände 010 bzw. 001 auftreten. Durch den Zustand 010 wird angezeigt, dass die Diode D4 leitend ist, wogegen der Zustand 001 anzeigt, dass die Diode D6 leitend ist. Das heißt, der Wechsel vom Zustand 100 zum Zustand 010 signalisiert ein Restdrehfeld RDF und der Wechsel vom Zustand 100 zum Zustand 001 signalisiert ein Linksdrehfeld LDF. In diesem Zustandsdiagramm sind jeweils die drei Zustände von einem Rechts- und Linksdrehfeld RDF und LDF des Motors 4 dargestellt. Eine Änderung der Folge dieser drei Zustände eines Rechts- bzw. Linksdrehfeldes RDF bzw. LDF signalisieren einen Phasenbruch Pb.

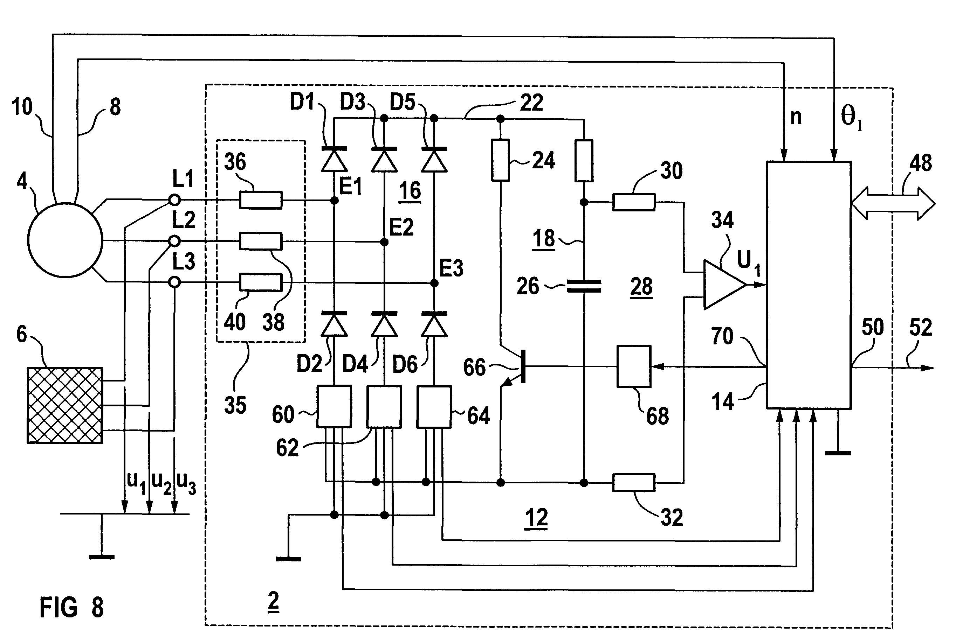

In der FIG 8 ist eine besonders vorteilhafte Ausführungsform der Vorrichtung 2 näher dargestellt. Diese Ausführungsform unterscheidet sich von der Ausführungsform nach FIG 5, dadurch, dass die Triggerschaltungen 54, 56 und 58 durch Optokoppler 60, 62, 64 ersetzt sind. Diese Optokoppler 60, 62, 64 sind sendeseitig jeweils elektrisch in Reihe zu einer Diode D2, D4 und D6 der unteren Brückenseite der mehrphasigen Diodenbrücke 16 der analogen Auswerteschaltung 12 geschaltet. Empfangsseitig ist jeder Optokoppler 60, 62 und 64 mit einem Signaleingang der digitalen Recheneinheit verbunden. Durch die Verwendung von Optokopplern 60, 62 und 64 anstelle der Triggerschaltungen 54, 56 und 58 werden die Leitendzustände der Dioden D2, D4 und D6 potentialfrei ermittelt.

Ein weiterer Unterschied dieser Ausführungsform zur Ausführungsform nach FIG 5 besteht darin, dass dem hochohmigen Widerstand 24 ein elektrischer Schalter 66 elektrisch in Reihe geschaltet ist. Der Steuereingang dieses elektrischen Schalters 66 ist mittels eines Optokopplers 68 mit einem Steuerausgang 70 der digitalen Recheneinheit 14 potential getrennt verknüpft. Bei diesem elektrischen Schalter 66, der hier ein Transistor ist, wird der hochohmige Widerstand 24 elektrisch parallel zum gleichspannungsseitigen Ausgang der mehrphasigen Diodenbrücke 16 geschaltet. Jedes Mal, wenn der hochohmige Widerstand 24 eingeschaltet ist, fließt ein Strom durch die Dioden D1,...,D6. Um die Drehrichtung des Motors 4 bzw. einen Phasenbruch detektieren zu können, braucht der Strom pro Diode D1,...,

D6 nicht während eines vollen 60°el.-Blocks zu fließen. Es genügt ein Bruchteil eines jeden 60°el.-Stromblocks. Die Größe dieses Bruchteils bestimmt die Verminderung der am hochohmigen Widerstand 24 auftretenden Verlustleistung. Werden diese Bruchteile der 60°el.-Stromblöcke jeweils auf die positiven bzw. negativen Kommutierungszeitpunkte Kp bzw. Kn (natürlichen Kommutierungspunkte eines dreiphasigen Netzes) synchronisiert, so lässt sich neben der Drehrichtungserkennung auch noch die Netzfrequenz $f_N$ ermitteln. Dieser getaktete hochohmige Widerstand 24 kann auch bei den Ausführungsformen nach FIG 1 bzw. 5 verwendet werden.

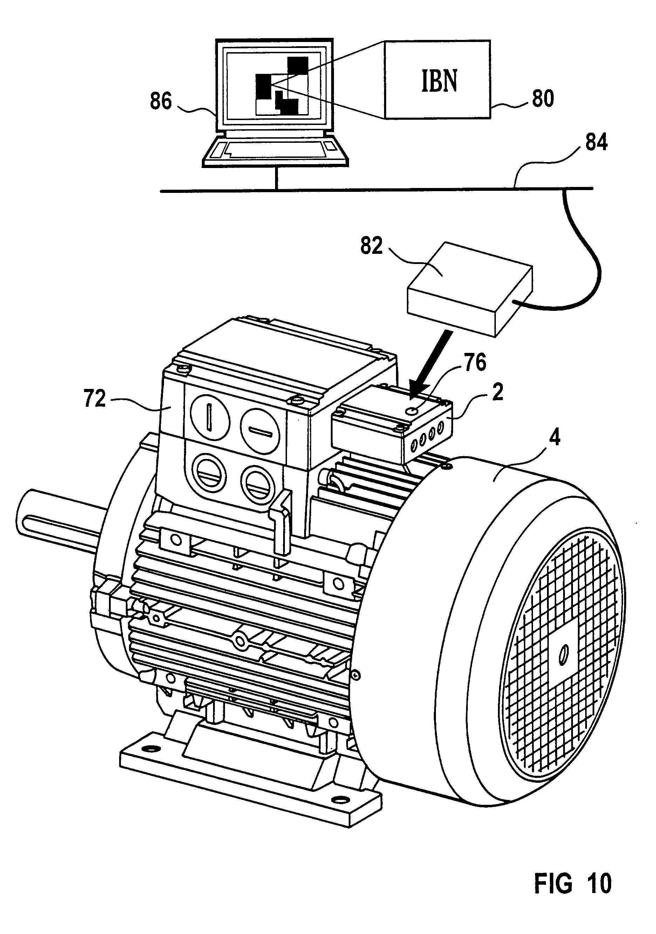

Die FIG 9 zeigt einen Motor 4 kleiner Achshöhe mit einer Vorrichtung 2 nach der FIG 1 bzw. 5 bzw. 8. Diese Vorrichtung 2 ist in den Klemmenkasten 72 dieses Motors 4 angeordnet, so dass die Vorrichtung 2 fest dem Motor 4 zugeordnet ist. Dadurch kann diese Vorrichtung 2 nicht an einen anderen Motor 4 angebaut werden. Damit diese Vorrichtung 2 gegen öffnen von unberechtigten Personen geschützt ist, ist dieser als verschlossene Einheit in den Klemmkasten 72 integriert bzw. gemäß FIG 10 an den Klemmkasten 72 montiert. Die Verkabelung des Drehzahlsensors und des Temperatursensors erfolgt vorteilhaft im Inneren des Motors 4. Hierfür müssten im Blechpaket des Motors 4 entsprechende Durchbrüche vorgesehen werden, um die Sensorleitung von der B-Seite des Motors in den Klemmkasten 72 zu führen. Die Kommunikationsbaugruppe 74 ist kein Bestandteil der Vorrichtung 2. Diese Kommunikationsbaugruppe 74 ist so gestaltet, dass diese auf das Gehäuse der Vorrichtung 2 aufgesteckt werden kann. Bei abgezogener Baugruppe 74 wird der Steckanschluss 76 mit einem Deckel verschlossen. Mittels dieser Kommunikationsbaugruppe 74 ist die Vorrichtung 2 mit einer Programmiereinrichtung 78 verbunden, die ein Programmiertool 80 aufweist. Mittels dieser Programmiereinrichtung 78 wird die Vorrichtung 2 des Motors 4 parametriert. Außerdem können zusätzliche Parameter einer Arbeitsmaschine abgespeichert werden. Diese Kommunikationsbaugruppe 74 wird nach erfolgter Parametrierung von der Vorrichtung 2 abgezogen. Ein derartiger Motor 4 mit festzugeordneter Vorrichtung 2 kann als "intelligenter" Motor bezeichnet werden, da die Vorrichtung 2 den Betriebszustand des Motors 4 ermittelt und bei nicht erlaubtem Betriebszustand eine Meldung über die Meldeleitung 52 an eine dezentrale Steuerung abgibt bzw. auch mittels dieser Meldeleitung 52 ein Schütz betätigt, um ggf. den Motor 4 durch Unterbrechung des Steuerstromkreises des Hauptschützes abzuschalten.

In der FIG 10 ist ein Motor 4 großer Achshöhe mit einer Vorrichtung 2 nach FIG 1 bzw. 5 bzw. 8 dargestellt. Bei dieser Darstellung ist die Vorrichtung 2 direkt am Klemmkasten 72 des Motors 4 angebracht. Bei dieser Darstellung wird die Vorrichtung 2 mittels einer Busanschaltbaugruppe 82 parametriert. Diese Busanschaltbaugruppe 82 wird wie die Kommunikationsbaugruppe 74 auf die Vorrichtung 2 gesteckt. Gegenüber der Ausführung gemäß der FIG 9 ist die Busanschaltbaugruppe 82 mit einem Bussystem 84 verbunden, dass eine zentrale Steuerungseinrichtung 86 aufweist. Diese Steuerungseinrichtung 86 verfügt ebenfalls über ein Programmiertool 80. Mit dieser Busanschaltbaugruppe 82 ist der "intelligente" Motor 4 ständig mit der zentralen Steuerungseinrichtung 86 verbunden.

**Patentansprüche**

1. Verfahren zur Ermittlung eines Betriebszustandes eines an einem starren Netz (6) angeschlossenen Motors (4), der einen Drehzahlsensor aufweist, wobei aus an Anschlussklemmen (L1, L2, L3) des Motors (4) anstehenden Phasenspannungen ($u_1$, $u_2$, $u_3$) des starren Netzes (6) dessen Frequenz $f_N$ und Amplitude ($U_1$) ermittelt werden, wobei aus einer gemessenen Wellendrehzahl (n) und einer Polpaarzahl (p) des Motors (4) in Abhängigkeit der ermittelten Netzfrequenz ($f_N$) ein Schlupf (s) des Motors (4) berechnet wird, wobei in Abhängigkeit dieses Schlupfes (s), einer ermittelten Amplitude ($U_1$) des Netzes (6) und vorbestimmter motorspezifischer Parameter ($X_h$, $X_1$, $X_2$, $R_{fe}$, $R_1$, $R_2$, $\sigma$, X) eine Amplitude ($U_{11}$) einer Spannung, die der Amplitude (U1) des Netzes (6) vermindert um den Spannungsabfall am Ständerwiderstand (R1) entspricht, und wobei in Abhängigkeit dieser zuvor berechneten Werte eine mechanische Wellenleistung ($P_{mech}$) gemäß folgender Gleichung:

$$P_{mech} = 3 \cdot X_h^2 / X_1^2 \cdot U_{11}^2 \cdot R_2 \cdot s / \left( R_2^2 + (\sigma \cdot X_2 \cdot s)^2 \right) \cdot (1 - s)$$

berechnet wird.

2. Verfahren nach Anspruch 1, wobei in Abhängigkeit der motorspezifischen Parameter ($X_h$, $X_1$, $X_2$, $R_2$, $\sigma$), des berechneten Schlupfes (s) des Motors (4), der ermittelten Amplitude ($U_1$) des starren Netzes (6) und des einphasigen Ersatzschaltbildes des Motors (4) der Motorstrom ($I_1$) berechnet wird.

3. Verfahren nach Anspruch 1, wobei mittels einer Auswertung einer zeitlichen Abfolge ermittelter Spannungsabschnitte der an Anschlussklemmen (L1, L2, L3) des Motors (4) anstehenden Phasenspannungen ($u_1$, $u_2$, $u_3$) des starren Netzes (6) eine Drehrichtung (RDF, LDF) des Netzes (6) an den Anschlussklemmen (L1, L2, L3) des Motors (4) ermittelt wird.

4. Verfahren nach Anspruch 1, wobei mittels einer Auswertung einer zeitlichen Abfolge ermittelter Spannungsabschnitte der an Anschlussklemmen (L1, L2, L3) des Motors (4) anstehenden Phasenspannungen ($u_1$, $u_2$, $u_3$) des starren Netzes (6) und einer Amplitudenauswertung dieser Spannungsabschnitte ein Phasenausfall (Pb) des Netzes (6) ermittelt wird.

5. Verfahren nach Anspruch 1 und 3, wobei in Abhängigkeit einer gemessenen Wellendrehzahl (n) und der Ermittlung des Drehfeldes des starren Netzes (6) auf eine Blockierung des Motors (4) geschlossen wird.

6. Verfahren nach Anspruch 1, wobei in Abhängigkeit des berechneten Schlupfes (s) und der berechneten mechanischen Wellenleistung ($P_{mech}$) die Luftspaltleistung ($P_{LS}$) gemäß folgender Gleichung:

$$P_{LS} = P_{mech} / (1 - s)$$

berechnet wird.

7. Verfahren nach Anspruch 1 und 6, wobei in Abhängigkeit des berechneten Schlupfes (s) des Motors (4) und der berechneten Luftspaltleistung ($P_{LS}$) die Verlustleistung $P_{V2}$ des Läufers des Motors (4) gemäß folgender Gleichung:

$$P_{V2} = P_{LS} \cdot s$$

berechnet wird.

8. Verfahren nach Anspruch 2 und 7, wobei in Abhängigkeit des berechneten Motorstromes ($I_1$) und der motorspezifischen Parameter ($R_1$, $R_{FE}$) die Verlustleistung ($P_{V1}$) im Ständer des Motors (4) berechnet wird.

9. Verfahren nach Anspruch 1, 7 und 8, wobei in Abhängigkeit der mechanischen Wellenleistung ($P_{mech}$) und der gemessenen Wellendrehzahl (n) die vom Motor (4) aufgenommene Wirkleistung (P) ermittelt wird, aus der anschließend in Abhängigkeit der berechneten Verlustleistungen ($P_{V1}$, $P_{V2}$) im Ständer und im Läufer der Wirkungsgrad ($\eta$) des Motors (4) bestimmt wird.

10. Verfahren nach einem der vorgenannten Ansprüche, wobei mittels einer gemessenen Temperatur ($\theta_1$) des Ständers und eines thermischen Modells des Motors (4) die Temperatur ($\theta_2$) des Läufers ermittelt wird.

11. Verfahren nach Anspruch 10, wobei in Abhängigkeit der Ständer- und Läufertemperatur ($\theta_1$, $\theta_2$) und vorbestimmter Temperaturbeiwerte ($\kappa_1$, $\kappa_2$) die motorspezifischen Parameter ($R_1$, $R_2$) gemäß folgender Gleichung:

$$R(T) = R_{20} \cdot (1 + \kappa \cdot (T - T_{20}))$$

korrigiert werden.

12. Vorrichtung (2) zur Ermittlung eines Betriebszustandes eines an einem starren Netz (6) angeschlossenen Motor (4), der einen Drehzahlsensor aufweist, wobei diese Vorrichtung (2) eine digitale Recheneinheit (14) und eine analoge Auswerteschaltung (12) aufweist, die mit ihren Eingängen (E1, E2, E3) mit den Anschlussklemmen (L1, L2, L3) des Motors (4) und ausgangsseitig mit Eingängen der digitalen Recheneinheit (14) verknüpft ist, wobei der Drehzahlsensor ausgangsseitig mit einem Eingang der digitalen Recheneinheit (14) verbunden ist.

13. Vorrichtung (2) nach Anspruch 12, wobei die analoge Auswerteschaltung (12) eingangsseitig eine mehrphasige Diodenbrücke (16) und ausgangsseitig ein RC-Glied (18) aufweist, das eingangsseitig elektrisch parallel zum hochohmigen kurzgeschlossenen Ausgang der mehrphasigen Diodenbrücke (16) geschaltet ist und wobei ein positiver Anschluss (22) des Ausgangs der mehrphasigen Diodenbrücke (16) mit einer Einrichtung (20) zur Unterdrückung eines Gleichanteils verknüpft ist.

**14.** Vorrichtung (2) nach Anspruch 12, wobei die analoge Auswerteschaltung (12) eingangsseitig eine mehrphasige Diodenbrücke (16) und ausgangsseitig ein RC-Glied (18) aufweist, das eingangsseitig elektrisch parallel zum hochohmig kurzgeschlossenen Ausgang der mehrphasigen Diodenbrücken (16) geschaltet ist, und wobei jeder Eingang (E1, E2, E3) der analogen Auswerteschaltung (12) mit einem Eingang einer Triggerschaltung (54, 56, 58) verbunden ist, die ausgangsseitig jeweils mit einem Eingang der digitalen Recheneinheit (14) verknüpft sind.

**15.** Vorrichtung (2) nach Anspruch 12, wobei die analoge Auswerteschaltung (12) eingangsseitig eine mehrphasige Diodenbrücke (16) und ausgangsseitig ein RC-Glied (18) aufweist, das eingangsseitig elektrisch parallel zum hochohmig kurzgeschlossenen Ausgang der mehrphasigen Diodenbrücke (16) geschaltet ist, und wobei die Dioden (D1,D3,D5; D2,D4,D6) der oberen oder unteren Diodenseite jeweils elektrisch in Reihe mit einem Optokoppler (60, 62, 64) geschaltet sind, deren Signalausgänge jeweils mit einem Eingang der digitalen Recheneinheit (14) verbunden sind.

**16.** Vorrichtung (2) nach einem der Ansprüche 14 und 15, wobei der Widerstand (24) des hochohmigen kurzgeschlossenen Ausgangs der mehrphasigen Diodenbrücke (16) elektrisch in Reihe mit einem elektrischen Schalter (66) geschaltet ist, dessen Steuereingang potentialgetrennt mit einem Ausgang (70) der digitalen Recheneinheit (14) verbunden ist.

**17.** Vorrichtung (2) nach einem der Ansprüche 14 bis 16, wobei das RC-Glied (18) ausgangsseitig einen Pegelumsetzer (28) aufweist.

**18.** Vorrichtung (2) nach Anspruch 12, wobei der analogen Auswerteschaltung (12) eine Einrichtung (35) zur sicheren elektrischen Trennung vorgeschaltet ist.

**19.** Vorrichtung (2) nach Anspruch 18, wobei die Einrichtung (35) für jeden Eingang der analogen Auswerteschaltung (12) einen hochohmigen Widerstand (36, 38, 40) aufweist.

**20.** Vorrichtung (2) nach Anspruch 18, wobei die Einrichtung (35) ein Mehrphasentransformator ist.

**21.** Vorrichtung (2) nach Anspruch 18, wobei die Einrichtung (35) für jeden Eingang der Auswerteschaltung (12) einen Einphasentransformator aufweist.

**22.** Vorrichtung (2) nach Anspruch 18, wobei die Einrichtung (35) ein Pegelumsetzer (28) ist.

**23.** Vorrichtung (2) nach einem der vorgenannten Ansprüche, wobei in einer Ständerwicklung des Motors (4) ein Temperaturfühler angeordnet ist, der ausgangsseitig mit einem Eingang der digitalen Recheneinheit (14) verknüpft ist.

**24.** Vorrichtung (2) nach einem der vorgenannten Ansprüche, wobei der Drehzahlsensor im Inneren des Motors (4) angebracht ist.

**25.** Vorrichtung (2) nach einem der vorgenannten Ansprüche, wobei der Drehzahlsensor ein einfacher Strichgeber ist.

**26.** Vorrichtung (2) nach einem der Ansprüche 12 bis 23, wobei der Drehzahlsensor ein Zahnradgeber ist.

**27.** Vorrichtung (2) nach einem der vorgenannten Ansprüche, wobei die digitale Recheneinheit (14) ein Mikroprozessor ist.

**28.** Vorrichtung (2) nach einem der Ansprüche 12 bis 25, wobei die digitale Recheneinheit (14) ein Programmable Logic Device ist.

**29.** Vorrichtung (2) nach einem der vorgenannten Ansprüche, wobei die Vorrichtung direkt am Motor (4) angebracht ist.

**30.** Vorrichtung (2) nach Anspruch 28, wobei die Vorrichtung (2) und der Klemmkasten (72) des Motors (4) eine Baueinheit bilden.

**31.** Vorrichtung (2) nach einem der vorgenannten Ansprüche, wobei die Vorrichtung zugriffsgeschützt ausgestaltet ist.

**32.** Vorrichtung (2) nach einem der vorgenannten Ansprüche, wobei die Vorrichtung (2) mit einem Steckanschluss (76) zum Kontaktieren einer weiteren Einheit aufweist.

33. Vorrichtung (2) nach Anspruch 32, wobei die weitere Einheit eine Kommunikationsbaugruppe (74) ist.

FIG 1

FIG 2

FIG 6

FIG 3

$$R_1 \quad i_1 \quad X_1\sigma \qquad\qquad X_2\sigma$$

$$U_1 \qquad U_{11} \quad R_{Fe} \qquad X_h \qquad\qquad R_2/S$$

**FIG 4**

IBN

78

80

76

2

74

72

4

**FIG 9**

FIG 5

FIG 7

EP 1 204 185 A2

FIG 8

EP 1 204 185 A2

FIG 10